Europäisches Patentamt

European Patent Office

Office européen des brevets

(11) Publication number: **0 228 177**
**A2**

# (12) EUROPEAN PATENT APPLICATION

(21) Application number: **86308946.2**

(22) Date of filing: **17.11.86**

(51) Int. Cl.⁴: **G01N 27/90**

(30) Priority: **19.11.85 US 799434**

(43) Date of publication of application:
**08.07.87 Bulletin 87/28**

(84) Designated Contracting States:
**DE FR GB**

(71) Applicant: **ELECTRIC POWER RESEARCH INSTITUTE, INC**
**3412 Hillview Avenue**
**Palo Alto California 94303(US)**

(72) Inventor: **Johnson, Duane P.**
**34 West Poplar Avenue**
**San Mateo California 94402(US)**

(74) Representative: **Jackson, David Spence et al**
**REDDIE & GROSE 16, Theobalds Road**
**London, WC1X 8PL(GB)**

(54) **Flexible eddy-current coil and coil array for nondestructive testing.**

㉗ An array of flexible coils (50) on a flexible substrate (52) can be flexed to conform to the geometry of the surface undergoing test. Photoresist masking and etching techniques are employed to fabricate the electrically conductive coil array on the surface of the substrate. A large array of coils (50) is readily fabricated using batch fabrication techniques.

FIG. — 6

SMALL 2D 6X10 ELEMENT ARRAY
VERSION 1.0 Y.K. OCT. 8 1985

ELEMENT OD = 0.2"
ID = 0.05"

OUTER WINDING INTER-CONNECTIONS.
LOCATED ON THE COIL SIDE OF THE SUBSTRATE

INNER WINDING INTER-CONNECTIONS.
LOCATED ON THE BACK SIDE OF THE SUBSTRATE

FLEX. SUBSTRATE

RIGID CKT. CARD

SCALE 1:1 (APPROX.)

## FLEXIBLE EDDY-CURRENT COIL AND COIL ARRAY FOR NONDESTRUCTIVE TESTING

This invention relates generally to nondestructive testing, and more particularly the invention relates to a flexible eddy-current coil and coil array for non destructive testing.

Nondestructive examination techniques are commonly used to detect surface cracks in metallic structures. The three primary surface flaw non destructive testing techniques are penetrant testing, magnetic particle testing, and eddy-current testing. Each technique has advantages and disadvantages. Eddy current testing exhibits the highest sensitivity and allows superficial indications such as surface irregularities to be distinguished from real defects. This technique does not require extensive surface preparation or cleaning, and the technique can work on ferrous and non-ferrous magnetic metals. Further, eddy-current testing does not require post test cleaning and can provide a permanent test record.

Primary limitations of the eddy-current test technique are geometric in nature. For example, to achieve high sensitivity and accurate defect resolution, the sensing element must both conform to the part and have a small discrete sensing area that is scanned over the test piece. Inspecting a complex part with eddy-current methods requires multiple probes specifically designed for each local geometry. To inspect a large area for small defects, complete coverage requires many scans.

Heretofore most eddy-current coils have been hand wound and thus are relatively expensive to manufacture. Furthermore, the hand crafted nature of the eddy-current probe fabrication process results in significant variability in coil impedance and sensitivity to the test piece.

The use of coils formed on printed circuit boards has been proposed as reported by Bahr and Watjen in " Novel Eddy Current Probe Development " in Project Report No. AFWAL-TR-31-4159. As noted in the report coils were formed on rigid substrates using photoresist masking and etching techniques which improved the detect sensitivity and coil reproducibility. However since the rigid coil only conforms to a flat test piece, the improved defect sensitivity would not carry over to most practical geometries when the test area is not flat. In addition to the rigid substrate the coil traces were so wide that only six turns could be achieved within the desired coil size. Due to the limited number of turns the inductance was too low to permit effective utilization of the probe below 10 MHz. Finally, no consideration was given in the above project to the fabrication of an array of coils to reduce or eliminate the probe scanning requirements.

Accordingly, an object of the present invention is an improved eddy-current coil for use in non destructive test systems.

Another object of the invention is an eddy-current coil array which can conform to the geometry of the surfaces examined.

Yet another object of the invention is an eddy-current coil or coil array which is readily produced using a batch process technology.

A feature of the invention is a flexible substrate on which coils are formed using photoresist masking and etching techniques.

The invention and objects and features thereof will be more readily apparent from the following detailed description and appended claims when taken with the drawing, in which:

Figure 1 is a plan view of a eddy-current coil in accordance with one embodiment of the invention.

Figure 2 is a section view taken along the line 2-2 of Figure 1 and illustrating the geometry and spacing of coil turns.

Figure 3 is a section view taken along the line 3-3 of Figure 1 illustrating the coil and bridge structure.

Figure 4 is a plan view of a test array of flexible coils.

Figure 5 is a functional block diagram of an eddy-current test system using an array in accordance with the invention.

Figure 6 is a plan view of an array of coils fabricated on a plug-in coil.

Figure 7 is an enlarged portion of the array of coils in Figure 6 illustrating the interconnections of the coils.

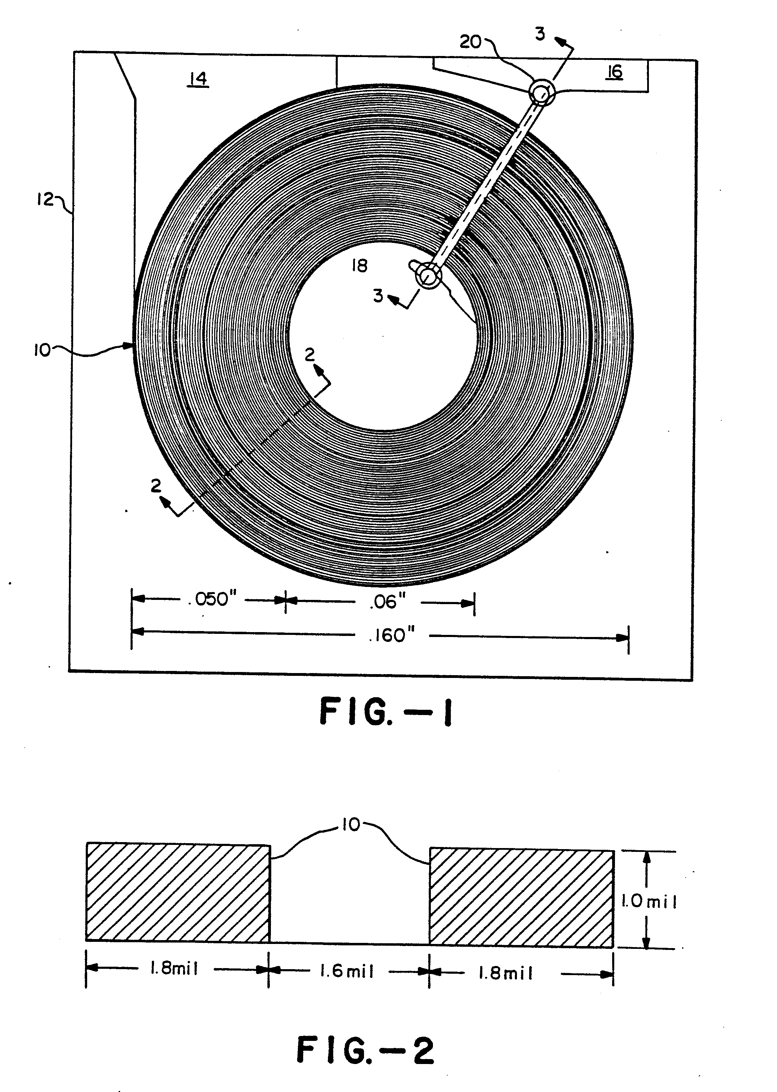

Referring now to the drawings, Figure 1 is a plan view of one embodiment of the invention in which a 15 turn spiral coil 10 is fabricated on a flexible polyimide (e.g. KaptonTM) substrate 12. The coil is formed by vapor depositing a one mil copper layer on the surface of the polyimide layer 12 and then defining the coil pattern using conventional photoresist masking and etching techniques. As noted, the coil has an overall diameter of 0.160 inch with the distance from the inside coil to the outside coil being 0.050 inch. The outside coil turn electrically and mechanically contacts a pad 14, and the inside coil turn is connected to a pad 16 by means of plated through holes 18, 20 and a conductive bridge 22 on the opposite surface of substrate 12.

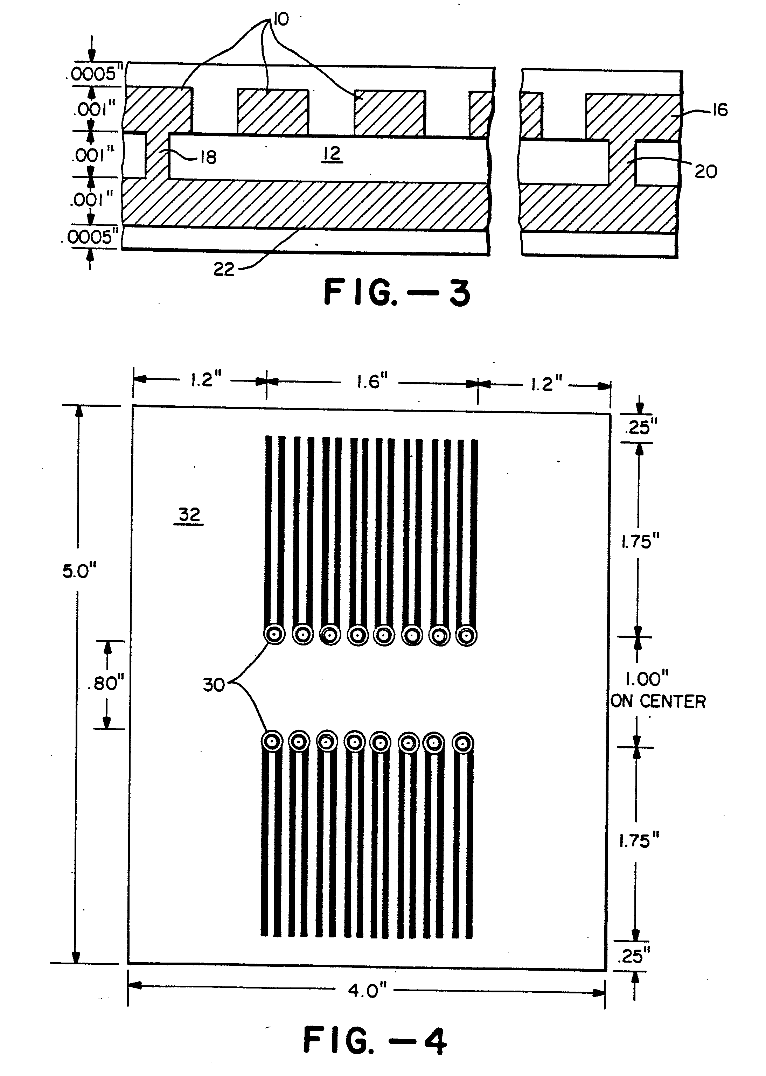

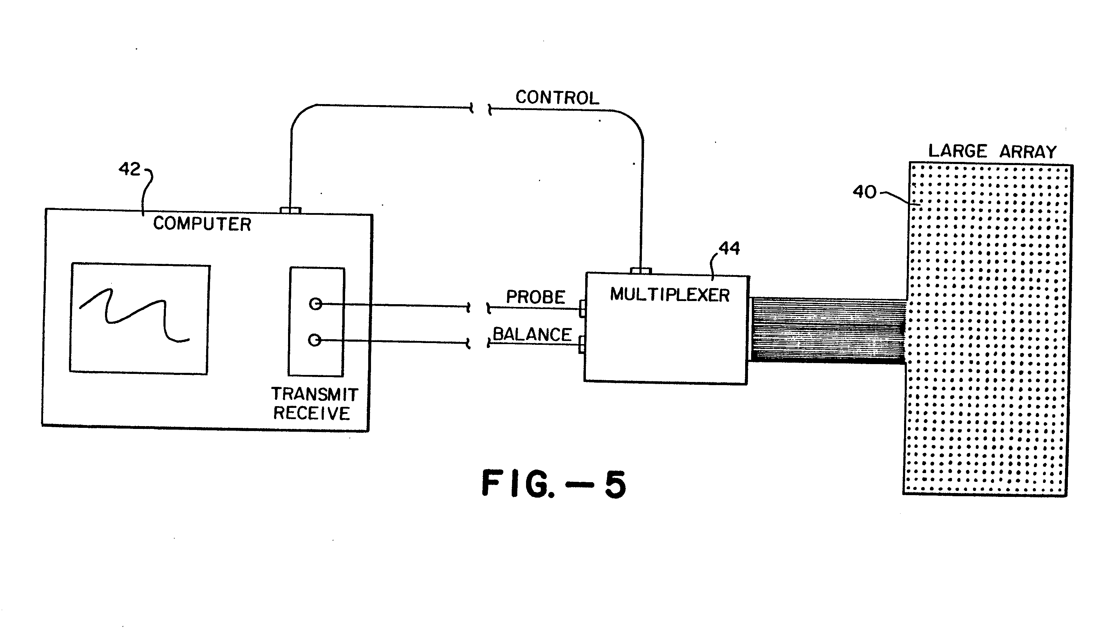

Figure 2 is a section view taken along the line 2-2 and further illustrates the 1.0 mil by 1.8 mil dimensions of each turn and the 1.6 mil spacing of the turns. Figure 3 is a section view taken along the line 3-3 of Figure 1 and further illustrates the coil 10 on one side of polyimide layer 12 and the bridge 22 on the opposite side of layer 12 which connects the inside turn to the outside pad 16 by means of the plated through holes 18 and 20. The coil is completed by applying polyimide layers over the surface of the coil 10 and over bridge 22 with a suitable adhesive to cover all exposed copper surfaces.

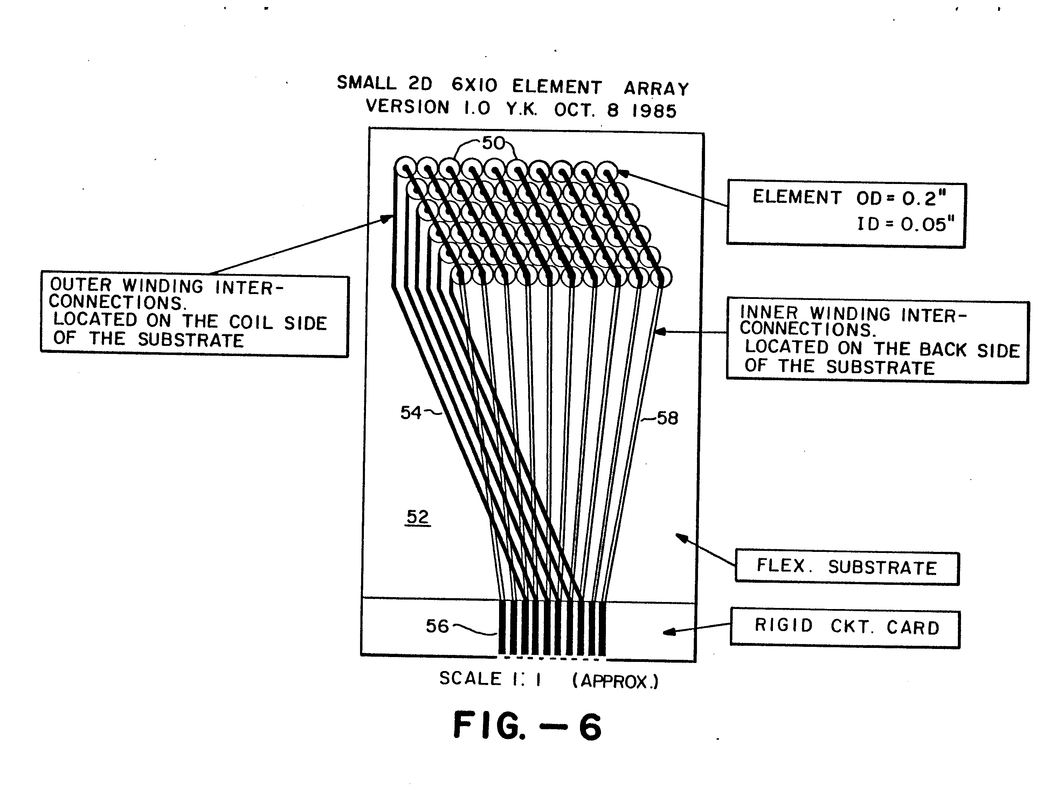

Figure 4 is a plan view of a linear array of eight coils 30 of the dimensions illustrated in Figure 1 which are formed on a polyimide substrate 32. The fabricated coils were tested to determine their general electrical characteristics and specific parameters related to their function as eddy-current test coils. Crack sensitivity and effective field size parameter were compared to those of a conventional ET probe as follows:

| Parameter | Flexible Coil | Standard Coil |
|---|---|---|
| Impedance magnitude in air | 17.6 | 66.7 |
| Impedance magnitude on copper | 8.5 | 41.6 |
| Change in impedance magnitude (air to copper) | 51.7% | 37.6% |
| Change in impedance magnitude at a crack | 9.4% | 0.5% |
| Effective field diameter | 0.16 inch | 0.13 inch |

Thus it is seen that the flexible coil provides improved signal characteristics as well as more flexibility in use.

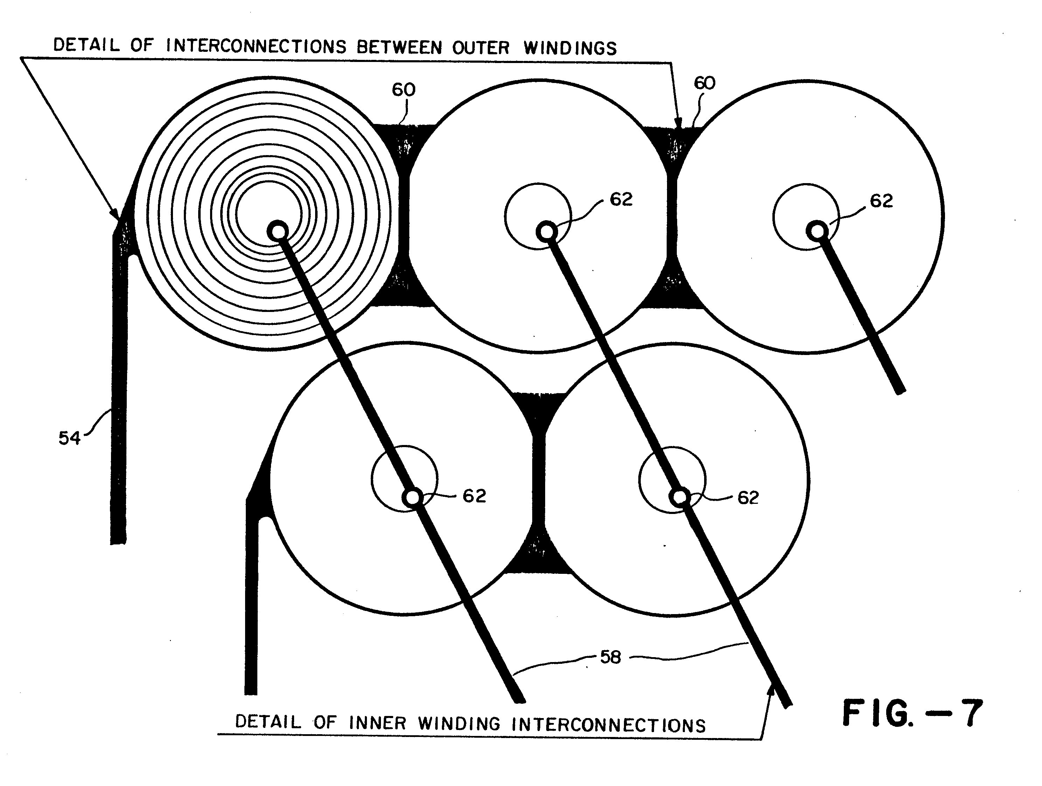

Figure 5 is a functional block diagram of an eddy-current test system utilizing a large array 40 of coils in accordance with the invention. The computer 42 controls the application of test signals generated in the eddy-current driver/detector through the multiplexer 44 to each of the coils and measures the changes in impedance of each of the coils. Advantageously, the array 40 can be flexed to conform to the surface of the structure undergoing examination and eliminate or greatly reduce the need to scan the structure under test.

Figure 6 is a plan view of an array of coils fabricated on a plug-in card. The structure is similar to that described above with reference to Figure 3 with the coils 50 fabricated on a flexible polyimide substrate 52. Leads 54 interconnect connector bars 56 to the exterior windings of the coils in each row of coils, and leads 58 on the backside of substrate 52 interconnect connector bars on the backside to the interior windings of the coils in each inclined column of coils. Accordingly, any one coil can be addressed by the proper selection of a row interconnect lead and a column interconnect lead.

Figure 7 illustrates the detail of the interconnections between outer windings of coils in each row and the interconnections of inner windings in each column. The outer windings are interconnected by metal plating 60 between coils in each row, and the leads 58 are connected to the inner windings by plated through holes 62.

There has been described an improved eddy-current coil array for non destructive testing. While the invention has been described with reference to specific embodiments, the description is illustrative of the invention and is not to be construed as limiting the invention. For example, other flexible substrate material is available for use in the array. Many thin film processes as used on the electronics industry are available to produce the small scale circuits. Thus, many applications and adaptions may occur to those skilled in the art without departing from the true spirit and scope of the invention as defined by the appended claims.

**Claims**

1. An eddy current coil array for detecting defects in a metallic surface with reduced scanning comprising:
a flexible electrically insulative substrate (52),
a plurality of electrically conductive coils (50) arranged in rows and columns formed on a surface of said substrate (52),
and means (56) for electrically and selectively contacting any one of said plurality of coils.

2. An eddy-current coil array according to claim 1, characterised in that the plurality of coils (50) comprise an electrically conductive material formed on said surface and selectively processed to define said plurality of coils.

An eddy-current coil array according to claim 2, characterised in that said electrically conductive material comprises copper and said coils (50) are defined using photoresist masking and chemical etching of said copper.

4. An eddy-current coil array according to claim 2, characterised in that said means for electrically contacting said plurality of coils includes contact pads (56) on said surface of the substrate (52), conductive bridges (58) on an opposite surface of said substrate, and plated through holes (62) interconnecting said bridges (58 and said contact pads (56).

5. An eddy-current coil array according to claim 4, characterised by flexible electrically insulative layers overlying said coils (50) and said bridges (58) and affixed to the substrate (52).

6. An eddy-current coil array according to claim 5, characterised in that the substrate (52) and the said layers comprise polyimide.

**FIG. — 1**

**FIG. — 2**

.0005"
.001"
.001"
.001"
.0005"

10

18     12

16

20

22

# FIG. — 3

1.2"     1.6"     1.2"

.25"

32

5.0"

1.75"

.80"

30

1.00"
ON CENTER

1.75"

.25"

4.0"

# FIG. — 4

FIG. — 5

0 228 177

SMALL 2D 6X10 ELEMENT ARRAY
VERSION 1.0 Y.K. OCT. 8 1985

ELEMENT OD = 0.2"
ID = 0.05"

OUTER WINDING INTER-CONNECTIONS.
LOCATED ON THE COIL SIDE OF THE SUBSTRATE

INNER WINDING INTER-CONNECTIONS.
LOCATED ON THE BACK SIDE OF THE SUBSTRATE

FLEX. SUBSTRATE

RIGID CKT. CARD

SCALE 1: 1 (APPROX.)

# FIG. — 6

0 228 177

DETAIL OF INTERCONNECTIONS BETWEEN OUTER WINDINGS

60

60

62

62

54

62

62

58

DETAIL OF INNER WINDING INTERCONNECTIONS

FIG. — 7

0 228 177